# EUROPEAN PATENT APPLICATION

(11) **EP 4 257 564 A1**
(43) Date of publication of application: **11.10.2023**
(21) Application number: 22745003.8
(22) Date of filing: 05.01.2022
(51) Int. Cl.: C03C 10/04, C03C 21/00, C03B 23/00, H05K 5/02

(54) **CHEMICALLY STRENGTHENED GLASS-CERAMIC, PREPARATION METHOD THEREFOR, AND ELECTRONIC DEVICE**

(30) Priority: 30.01.2021 CN 202110139590
(71) Applicant: Huawei Technologies Co., Ltd., Longgang District Shenzhen, Guangdong 518129 (CN)
(72) Inventor: CHEN, Shifeng, Shenzhen, Guangdong 518129 (CN); HUANG, Yihong, Shenzhen, Guangdong 518129 (CN); XU, Wenbin, Shenzhen, Guangdong 518129 (CN); ZENG, Zhou, Shenzhen, Guangdong 518129 (CN); LIN, Geng, Shenzhen, Guangdong 518129 (CN); CHEN, Jiejie, Shenzhen, Guangdong 518129 (CN); ZHU, Guangxiang, Shenzhen, Guangdong 518129 (CN)
(74) Representative: Körber, Martin Hans
(86) International application number: PCT/CN2022/070288
(87) International publication number: WO 2022/161125

(57) **Abstract**

A chemically strengthened glass ceramic is provided. Strengthening layers are respectively formed on opposite sides, and the strengthening layer includes a potassium strengthening layer and a sodium strengthening layer sequentially from a surface to an inside of the chemically strengthened glass ceramic. A depth of the potassium strengthening layer is 0.01 µm to 5 µm. A depth of the sodium strengthening layer is greater than or equal to 0.1t, where t is a thickness of the chemically strengthened glass ceramic. A glass ceramic raw material is accommodated in a forming mold, and a preheating process, a forming process, a crystallization process, and an annealing cooling process are sequentially performed to obtain a to-be-strengthened 3D glass ceramic. Crystallinity of the glass ceramic raw material is 5% to 75%, and a temperature of the crystallization process is greater than or equal to a temperature of the forming process. An average transmittance of the 3D glass ceramic in an optical wavelength range of 400 nm to 700 nm is greater than or equal to 85%; a b value of a Lab color chromaticity indicator is greater than or equal to -2.0; and a haze is less than or equal to 0.25%.

## Description

This application claims priority to Chinese Patent Application No. 202110139590.6, filed with the China National Intellectual Property Administration on January 30, 2021 and entitled "CHEMICALLY STRENGTHENED GLASS CERAMIC, PREPARATION METHOD THEREOF, AND ELECTRONIC DEVICE", which is incorporated herein by reference in its entirety.

### TECHNICAL FIELD

Embodiments of this application relate to the field of glass ceramic technologies, and in particular, to a chemically strengthened glass ceramic, a preparation method thereof, and an electronic device.

### BACKGROUND

Compared with the conventional aluminosilicate glass, glass ceramics have a higher Young's modulus to resist impact deformation, and have higher fracture toughness to suppress crack propagation. In addition, the glass ceramics can be further chemically strengthened to improve strength of the glass ceramics, so that application of the glass ceramics in the mobile phone glass cover field attracts much attention in the industry. However, at present, the glass ceramics are usually strengthened by using a conventional aluminosilicate glass strengthening process, and it is difficult for strengthened glass ceramics to maintain excellent impact resistance and drop resistance and maintain good weather resistance. In addition, when the glass ceramics are applied to the field of 3D cover, problems such as poor optical properties, low hot bending efficiency, and dimensional instability may occur due to a limitation of an existing hot bending process.

### SUMMARY

In view of this, an embodiment of this application provides a chemically strengthened glass ceramic. The chemically strengthened glass ceramic has excellent impact resistance and drop resistance, and also has good weather resistance.

Specifically, a first aspect of embodiments of this application provides a chemically strengthened glass ceramic. Strengthening layers are respectively formed on opposite sides of the chemically strengthened glass ceramic, and the strengthening layer includes a potassium strengthening layer and a sodium strengthening layer sequentially from a surface to an inside of the chemically strengthened glass ceramic. A depth of the potassium strengthening layer is 0.01 µm to 5 µm. A depth of the sodium strengthening layer is greater than or equal to 0.1t, where t is a thickness of the chemically strengthened glass ceramic. The chemically strengthened glass ceramic has suitable depths of the potassium strengthening layer and the sodium strengthening layer, excellent drop resistance, impact resistance and weather resistance (high-temperature and high-humidity environment resistance), and can be applied to an electronic device, to improve reliability of the electronic device and service life in a humid and hot environment, and finally improve market competitiveness of the electronic device.

In an implementation of this application, a depth of the strengthening layer is greater than or equal to 80 µm. A larger depth of the strengthening layer can enable the chemically strengthened glass ceramic to have higher drop resistance and improve the reliability of the electronic device.

In an implementation of this application, a compressive stress CS50 of the chemically strengthened glass ceramic at a depth of 50 µm of the strengthening layer is greater than or equal to 50 MPa. A higher CS50 value may guarantee a higher strength of a glass ceramic.

In an implementation of this application, an average tensile stress of the chemically strengthened glass ceramic is 35 MPa to 85 MPa. A suitable average tensile stress may ensure that a glass has a high strength and prevent fragments from being very small after the glass fails and is broken into the fragments.

In an implementation of this application, a concentration of a sodium element decreases monotonically in a thickness range of 0.01t to 0.1t from the surface to the inside of the chemically strengthened glass ceramic. This distribution characteristic is beneficial to improve mechanical properties of the glass.

In an implementation of this application, the chemically strengthened glass ceramic is maintained at a temperature of 85°C and a humidity of 85% for 120 hours or more, and no white sodium-containing compound is precipitated on the surface. The excellent weather resistance can improve adaptability of the glass under a high-temperature and high-humidity condition.

In an implementation of this application, the chemically strengthened glass ceramic is obtained by chemically strengthening a to-be-strengthened glass ceramic, and the to-be-strengthened glass ceramic includes the following components in mole percentage:
Li₂O: 10% to 25%;
SiO₂: 58% to 72%;
Na₂O and K₂O: 3% to 7%;
Al₂O₃: 2% to 8%;
P₂O₅+ZrO₂+TiO₂: 2% to 13%;
MgO+CaO+ZnO: 0% to 3%; and
B₂O₃: 0% to 5%.

In an implementation of this application, the to-be-strengthened glass ceramic includes a glass phase and a crystal phase, and the crystal phase includes at least one of castorite, lithium silicate, and lithium disilicate.

In an implementation of this application, a total mass content of the crystal phase in the to-be-strengthened glass ceramic is greater than or equal to 50%.

In an implementation of this application, the chemically strengthened glass ceramic includes a 2D chemically strengthened glass ceramic, a 2.5D chemically strengthened glass ceramic, or a 3D chemically strengthened glass ceramic.

In an implementation of this application, the thickness of the chemically strengthened glass ceramic is greater than or equal to 0.03 mm. The specific thickness may be selected based on an actual application requirement.

In an implementation of this application, an average transmittance of the chemically strengthened glass ceramic in an optical wavelength range of 400 nm to 700 nm is greater than or equal to 85%; a b value of a Lab color chromaticity indicator is greater than or equal to -2.0; and a haze is less than or equal to 0.25%. The chemically strengthened glass ceramic has excellent optical properties, to better meet an application requirement of an electronic device cover.

In an implementation of this application, a process capability index CPK of the 3D glass ceramic with a length tolerance and a width tolerance within ±0.1 mm is greater than or equal to 0.8.

In an implementation of this application, a Vickers hardness of the chemically strengthened glass ceramic is greater than or equal to 650 kgf/mm²; and an impact resistance strength of the chemically strengthened glass ceramic is greater than or equal to 0.07J. A higher Vickers hardness can effectively suppress crack propagation and improve impact resistance and drop resistance. A higher impact resistance strength can improve reliability of a product.

A second aspect of embodiments of this application provides a preparation method of the foregoing chemically strengthened glass ceramic. The method includes:
placing a to-be-strengthened glass ceramic in a first salt bath to perform a first step of ion exchange, where a strengthening salt of the first salt bath includes a sodium salt whose mass fraction is greater than or equal to 30%; and
placing a to-be-strengthened glass ceramic obtained after the first step of ion exchange in a second salt bath to perform a second step of ion exchange to obtain the chemically strengthened glass ceramic, where a strengthening salt of the second salt bath includes a potassium salt whose mass fraction is greater than or equal to 85% and a lithium salt whose mass fraction is 0.005% to 1%.

In an implementation of this application, a temperature of the first step of ion exchange is 380°C to 490°C and a time period is 3h to 24h; and a temperature of the second step of ion exchange is 370°C to 450°C and a time period is 2 mins to 240 mins.

In an implementation of this application, the to-be-strengthened glass ceramic includes a to-be-strengthened 3D glass ceramic, and the to-be-strengthened 3D glass ceramic is prepared in the following manner:
accommodating a glass ceramic raw material in a forming mold, and sequentially performing a preheating process, a forming process, a crystallization process, and an annealing cooling process to obtain the to-be-strengthened 3D glass ceramic, where crystallinity of the glass ceramic raw material is 5% to 75%, and a temperature of the crystallization process is greater than or equal to a temperature of the forming process.

In an implementation of this application, a temperature of the preheating process is within a range of 0°C to 780°C; the temperature of the forming process is within a range of 600°C to 800°C, and a forming pressure is within a range of 0 MPa to 0.9 MPa; the temperature of the crystallization process is within a range of 700°C to 900°C; and a temperature of the annealing cooling process is within a range of 0°C to 800°C.

Both a crystal phase and an amorphous phase of the glass ceramic have the possibility of ion exchange with the outside. This ion exchange characteristic, especially when participation of a crystal phase constituent in ion exchange damages a crystal phase structure, to form an amorphous constituent with poor stability, will result in reducing weather resistance of the glass after ion exchange. According to the preparation method of a chemically strengthened glass ceramic provided in this embodiment of this application, two-step ion exchange is performed, and a proper quantity of lithium salts are added to the salt bath of the second step of ion exchange, to obtain the strengthened glass ceramic having excellent drop resistance, impact resistance, and weather resistance. Existence of the lithium salt in the salt bath may introduce a proper quantity of lithium ions into the glass in the second step of ion exchange process. The lithium ions have greater accumulation effect than the sodium ions. When the lithium ions enter a glass network, the glass network may be more stable, and glass corrosion caused by sodium salt precipitation of the glass ceramic in a high-temperature and high-humidity environment can be suppressed. The existence of the lithium salt can also suppress ion exchange to some extent, reduce ion exchange of components in the crystal phase of the glass, and improve glass weather resistance.

A third aspect of embodiments of this application provides a 3D glass ceramic. An average transmittance of the 3D glass ceramic in an optical wavelength range of 400 nm to 700 nm is greater than or equal to 85%; a b value of a Lab color chromaticity indicator is greater than or equal to -2.0; and a haze is less than or equal to 0.25%.

In an implementation of this application, a Vickers hardness of the 3D glass ceramic is greater than or equal to 650 kgf/mm²; and a process capability index CPK of the 3D glass ceramic with a length tolerance and a width tolerance within ±0.1 mm is greater than or equal to 0.8.

In an implementation of this application, the 3D glass ceramic includes the following components in mole percentage:
Li₂O: 10% to 25%;
SiO₂: 58% to 72%;
Na₂O and K₂O: 3% to 7%;
Al₂O₃: 2% to 8%;
P₂O₅+ZrO₂+TiO₂: 2% to 13%;
MgO+CaO+ZnO: 0% to 3%; and
B₂O₃: 0% to 5%.

In an implementation of this application, the 3D glass ceramic includes a glass phase and a crystal phase, and a total mass content of the crystal phase in the 3D glass ceramic is greater than or equal to 50%.

In an implementation of this application, the 3D glass ceramic includes a chemically strengthened 3D glass ceramic, and a compressive stress layer is on a surface of the chemically strengthened 3D glass ceramic.

In an implementation of this application, a thickness of the 3D glass ceramic is greater than or equal to 0.03 mm.

A fourth aspect of embodiments of this application provides a preparation method of the foregoing 3D glass ceramic. The method includes:
accommodating a glass ceramic raw material in a forming mold, and sequentially performing a preheating process, a forming process, a crystallization process, and an annealing cooling process to obtain the 3D glass ceramic, where crystallinity of the glass ceramic raw material is 5% to 75%, and a temperature of the crystallization process is greater than or equal to a temperature of the forming process.

In an implementation of this application, a temperature of the preheating process is within a range of 0°C to 780°C; the temperature of the forming process is within a range of 600°C to 800°C, and a forming pressure is within a range of 0 MPa to 0.9 MPa; the temperature of the crystallization process is within a range of 700°C to 900°C; and a temperature of the annealing cooling process is within a range of 0°C to 800°C.

According to the preparation method of the 3D glass ceramic according to the embodiment of this application, 3D hot bending forming is performed on the glass ceramic raw material having medium crystallinity (5% to 75%), and the crystallization process is introduced after the forming process to prepare the 3D glass ceramic. In this way, a glass ceramic with high crystallinity may be finally obtained, and has both excellent optical properties and good drop resistance. In addition, 3D forming efficiency can be improved, a yield rate of 3D forming products is improved, and good dimensional stability is obtained.

An embodiment of this application further provides a glass cover. The glass cover is made of the chemically strengthened glass ceramic according to the first aspect and/or the 3D glass ceramic according to the third aspect. The glass cover may be a display cover, a rear cover, or a camera protective cover of an electronic device.

An embodiment of this application further provides an electronic device. The electronic device includes a housing assembled outside the electronic device and a circuit board located inside the housing. The housing uses a glass ceramic, and the glass ceramic includes the chemically strengthened glass ceramic according to the first aspect of embodiments of this application and/or the 3D glass ceramic according to the third aspect of embodiments of this application.

In some implementations of this application, the housing includes a display cover assembled on a front side of the electronic device, and the display cover includes the glass ceramic. In some other implementations of this application, the housing includes a rear cover assembled on a rear side of the electronic device, and the rear cover uses the glass ceramic. In some implementations of this application, the electronic device further includes a camera assembly located inside the housing. The housing includes a camera protective cover, the camera protective cover is disposed on the camera assembly, and the camera protective cover uses the glass ceramic. In an implementation of this application, the housing may be partially made of the glass ceramic, or may be entirely made of the glass ceramic. In the electronic device in this application, one or more of the display cover, the rear cover, and the camera protective cover may use the foregoing glass ceramic.

### BRIEF DESCRIPTION OF DRAWINGS

FIG. 1 is a schematic diagram of a structure of a front side of an electronic device according to an embodiment of this application;
FIG. 2 is a schematic diagram of a structure of a rear side of an electronic device according to an embodiment of this application;
FIG. 3 is a schematic diagram of a structure of a chemically strengthened glass ceramic according to an embodiment of this application;
FIG. 4 is a schematic diagram of exchange ion distribution of a strengthening layer of a chemically strengthened glass ceramic according to an embodiment of this application;
FIG. 5 is a stress curve diagram of a chemically strengthened glass ceramic according to an embodiment of this application, an existing aluminum-silicon one-time-strengthened glass, and an existing lithium-aluminum-silicon two-time-strengthened glass;
FIG. 6 is a temperature curve diagram of a hot bending forming process of a 3D glass ceramic according to an embodiment of this application; and
FIG. 7 is a schematic diagram of crystal phase changes inside a 3D glass ceramic in different heat treatment stages in a hot bending forming process according to an embodiment of this application.

### DESCRIPTION OF EMBODIMENTS

The following describes embodiments of this application with reference to accompanying drawings in embodiments of this application.

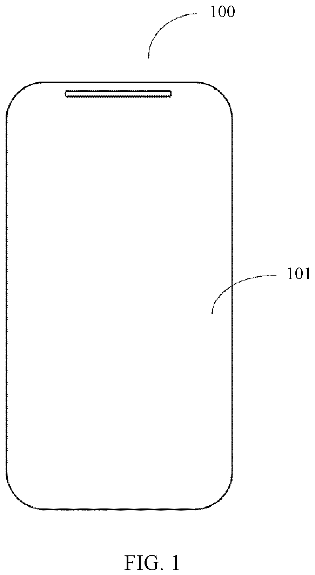

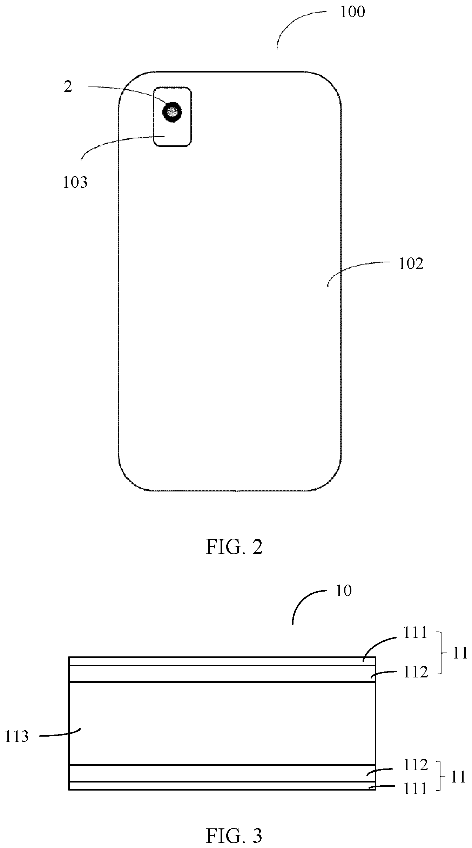

Refer to FIG. 1 and FIG. 2. An embodiment of this application provides an electronic device 100. The electronic device 100 may be an electronic product such as a mobile phone, a tablet computer, or a smart wearable device. The electronic device 100 includes a housing assembled outside the electronic device, and components such as a circuit board and a battery that are located inside the housing. The housing includes a display cover 101 assembled on a front side and a rear cover 102 assembled on a rear side. The display cover 101 is disposed on a display module, and the display cover 101 and/or the rear cover 102 are made of a glass ceramic. In this embodiment of this application, the display cover 101 and the rear cover 102 may be entirely made of the glass ceramic, or may be only partially made of the glass ceramic. In an implementation of this application, a display 200 may be a touch display, and the display cover 101 may be a protective cover disposed on the touch display. In an implementation of this application, the rear cover 102 may cover only the rear side (and a side that faces away from the display) of the electronic device 100, or may cover both the rear side and a side bezel of the electronic device 100. Optionally, the rear cover 102 may cover all side bezels around the electronic device, or may cover some of the side bezels.

In some implementations of this application, as shown in FIG. 2, the electronic device 100 further includes a camera assembly 2 located inside the housing. The housing may include a camera protective cover 103. The camera protective cover 103 is disposed on the camera assembly 2 to protect the camera assembly 2, and the camera protective cover 103 is made of the glass ceramic. In an implementation of this application, the camera protective cover 103 may be partially made of the glass ceramic, or may be entirely made of the glass ceramic. In an implementation of this application, a disposing position of the camera protective cover 103 depends on a disposing position of the camera assembly 2, and may be located on the front side of the electronic device 100, or may be located on the rear side of the electronic device 100. In some implementations of this application, the camera protective cover 103 may be a structure separated from the display cover 101 or the rear cover 102. In some other implementations of this application, the camera protective cover 103 may alternatively be an integrated structure with the display cover 101 or the rear cover 102.

In an implementation of this application, any one, any two, or all of the display cover 101, the rear cover 102, and the camera protective cover 103 in the electronic device 100 may be made of the glass ceramic.

Refer to FIG. 3. The foregoing glass ceramic used in the electronic device 100 is a chemically strengthened glass ceramic 10. Strengthening layers 11 are respectively formed on opposite sides of the chemically strengthened glass ceramic 10, and the strengthening layer 11 includes a potassium strengthening layer 111 and a sodium strengthening layer 112 sequentially from a surface to an inside of the chemically strengthened glass ceramic. A depth of the potassium strengthening layer 111 is 0.01 µm to 5 µm. A depth of the sodium strengthening layer 112 is greater than or equal to 0.1t, where t is a thickness of the chemically strengthened glass ceramic.

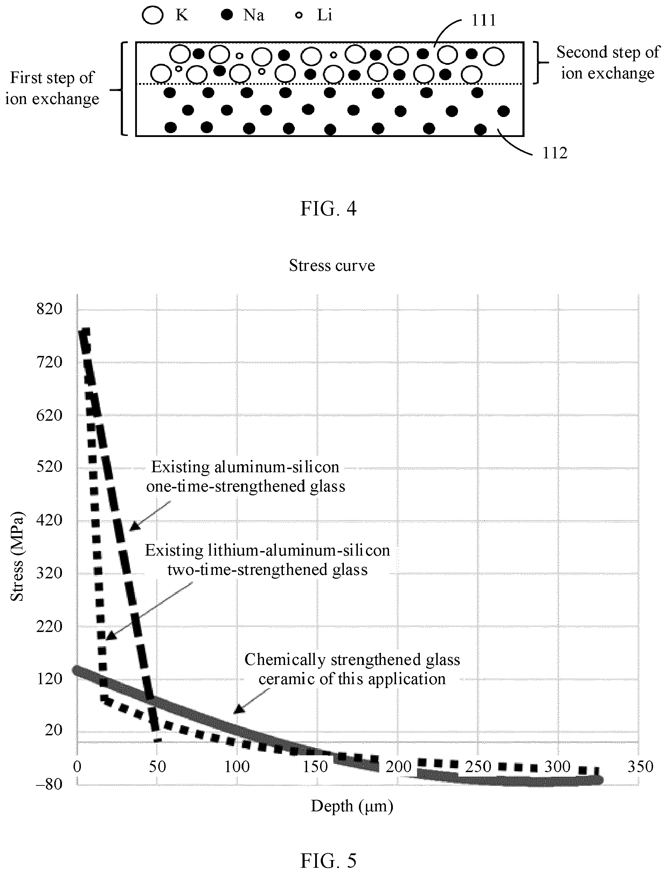

The chemically strengthened glass ceramic 10 in this embodiment of this application is obtained by chemically strengthening a to-be-strengthened glass ceramic. As shown in FIG. 3, the chemically strengthened glass ceramic 10 includes an intermediate layer 113 and strengthening layers 11 located on both sides of the intermediate layer 113. The strengthening layer 11 is obtained by performing two steps of ion exchange on the to-be-strengthened glass ceramic, and a part that is of the intermediate layer 113 and that does not participate in the ion exchange has the same composition as the to-be-chemically-strengthened glass ceramic. Refer to FIG. 4. The sodium strengthening layer 112 at an inner layer is formed by performing the first step of ion exchange. The first step of ion exchange is Na+-Li+exchange, and the first step of ion exchange introduces sodium ions into the glass ceramic. The potassium strengthening layer 111 at an outer layer is formed by jointly performing the first step of ion exchange and the second step of ion exchange. The second step of ion exchange includes K+-Na+ and Na+-Li+exchange, and the second step of ion exchange introduces potassium ions and lithium ions into the glass ceramic at the same time. The potassium strengthening layer 111 and the sodium strengthening layer 112 of suitable depths enable the glass to have excellent drop resistance and weather resistance. It should be noted that FIG. 4 only illustrates that K, Na, and Li are introduced into the glass in the two steps of ion exchange, and a distribution position of each component and a quantity of components are not limited to those shown in FIG. 4. For example, Li introduced into the second step of ion exchange may not be limited to only being introduced into the potassium strengthening layer, and may also be introduced into the sodium strengthening layer. The depths of the potassium strengthening layer and the sodium strengthening layer mean a dimension from the surface of the glass inward to a boundary of the corresponding layer. In some implementations, the depth of the potassium strengthening layer 111 is 0.1 µm to 3 µm. In some implementations, the depth of the potassium strengthening layer 111 is 0.5 µm to 2.5 µm. In some other implementations, the depth of the potassium strengthening layer 111 is 1.0 µm to 2.0 µm. In some other implementations, the depth of the potassium strengthening layer 111 is 1.2 µm to 1.8 µm. In some other implementations, the depth of the potassium strengthening layer 111 is 1.5 µm to 1.6 µm. The depth of the potassium strengthening layer is controlled to a suitable thickness, so that good impact resistance of the glass can be maintained when excellent drop resistance and weather resistance are obtained.

A main principle of chemical strengthening is to exchange ions having larger radius (such as K+) in a molten salt with ions having smaller radius (such as Na+) in the glass to form a layer of compressive stress on the surface through "crowding effect" and form a strengthening layer with a depth. In this implementation of this application, the depth of the strengthening layer is a strengthening layer depth on a single side of the glass, namely, a depth from the surface of the glass to position at which the compressive stress is 0 inside the glass. The strengthening layer is an ion exchange layer, or a compressive stress layer. The surface of the glass may obtain a compressive stress through ion exchange. When the glass is subject to an external force, the compressive stress of the surface needs to be offset first, and then the glass is in a tensile state, so a strength of the glass is significantly improved after chemical strengthening. In addition, because the ion exchange forms a compressive stress layer of a depth on the surface of the glass, even if the external force forms a crack on the surface of the glass, the formed ion exchange layer may effectively prevent further expansion of the crack, thereby greatly improving the ability of the glass to resist the external force and significantly improving the strength of the glass. In some implementations, a depth of the strengthening layer 11 is greater than or equal to 80 µm. In some implementations, the depth of the strengthening layer 11 is greater than or equal to 90 µm. In some implementations, the depth of the strengthening layer 11 is greater than or equal to 100 µm. In some other implementations, the depth of the strengthening layer 11 is greater than or equal to 105 µm. In some other implementations, the depth of the strengthening layer 11 is greater than or equal to 110 µm. The strengthening layer 11 has a larger depth, and the chemically strengthened glass ceramic has better drop resistance, so that reliability of the electronic device can be improved.

In an implementation of this application, a compressive stress CS50 of the chemically strengthened glass ceramic 10 at a depth of 50 µm of the strengthening layer is greater than or equal to 50 MPa. That is, a compressive stress at a position which is 50 µm away from the surface of the glass ceramic inside the chemically strengthened glass ceramic is greater than or equal to 50 MPa. In this way, it can be ensured that the glass ceramic has a high strength. A larger CS50 value indicates better drop resistance of the glass. Specifically, in some implementations, CS50 is greater than or equal to 65 MPa. In some implementations, CS50 is greater than or equal to 100 MPa. In some other implementations, CS50 is greater than or equal to 130 MPa. In some other implementations, CS50 is greater than or equal to 170 MPa.

In an implementation of this application, the strengthening layer 11 constitutes a compressive stress layer, and a tensile stress layer corresponding to the compressive stress layer is further included in the chemically strengthened glass ceramic. In an implementation of this application, an average tensile stress of the chemically strengthened glass ceramic 10 is 35 MPa to 85 MPa. Specifically, the average tensile stress may be, for example, 35 MPa, 39 MPa, 45 MPa, 60 MPa, 70 MPa, or 85 MPa. When the average tensile stress is very small, the strength of the glass is poor. When the average tensile stress is very big, fragments are very small (≤ 2 mm) after the glass fails and is broken into the fragments. Therefore, the glass is not suitable for the electronic device. A suitable average tensile stress may ensure that the glass has a high strength and prevent fragments from being very small after the glass fails and is broken into the fragments. A size of fragments after the chemically strengthened glass ceramic in this embodiment of this application fails and is broken into the fragments is greater than 2 mm.

In an implementation of this application, an anti-falling ball impact strength of the chemically strengthened glass ceramic 10 is greater than or equal to 0.07J. In some implementations, the anti-falling ball impact strength of the chemically strengthened glass ceramic 10 is greater than or equal to 0.10J. In some other implementations, the anti-falling ball impact strength of the chemically strengthened glass ceramic 10 is greater than or equal to 0.15J. Ball falling means that a steel ball falls freely from a height to the surface of the glass. The anti-falling ball impact strength refers to the ability of the glass to keep undamaged when the glass is hit on the surface by a steel ball that falls freely from a height.

In an implementation of this application, a concentration of a sodium element decreases monotonically in a thickness range of 0.01t to 0.1t from the surface to the inside of the chemically strengthened glass ceramic 10. That is, the concentration of the sodium element decreases monotonically at a depth of 0.01t to a depth of 0.1t from the surface to the inside of the chemically strengthened glass ceramic. The sodium element distribution characteristic is beneficial for the glass to obtain better drop resistance and weather resistance.

In an implementation of this application, the chemically strengthened glass ceramic 10 has good humidity and heat resistance. Specifically, the chemically strengthened glass ceramic 10 is maintained at a temperature of 85°C and a humidity of 85% for 120 hours or more, and no white sodium-containing compound is precipitated on the surface. That is, no "whitening" corrosion mark appears on the surface of the chemically strengthened glass ceramic 10. In some implementations, the chemically strengthened glass ceramic 10 is maintained at a temperature of 85°C and a humidity of 85% for 180 hours or more, and no white sodium-containing compound is precipitated on the surface. In some implementations, the chemically strengthened glass ceramic 10 is maintained at a temperature of 85°C and a humidity of 85% for 240 hours or more, and no white sodium-containing compound is precipitated on the surface. The chemically strengthened glass ceramic has good humidity and heat resistance, can improve adaptability of the electronic device in humid and hot scenarios, and prolong service life of the electronic device.

In an implementation of this application, the depth of the strengthening layer, the compressive stress CS50 at the depth of 50 µm of the strengthening layer, and the average tensile stress may be obtained by using a glass stress meter (for example, an SLP2000 or an FSM6000). In this embodiment of this application, the chemically strengthened glass ceramic is tested by using the glass stress meter to test a stress of the potassium strengthening layer, and there is no stress stripe.

In an implementation of this application, a drop resistance height of the entire chemically strengthened glass ceramic 10 is greater than or equal to 1.5m. A method for testing the drop resistance height is to attach the chemically strengthened glass ceramic 10 to a 200g electronic device model, where the glass is horizontally dropped downwards onto a marble plate with 180# sandpaper attached on a surface of the marble plate, and a highest point at which the glass does not break is taken as the drop resistance height.

In an implementation of this application, the to-be-strengthened glass ceramic is a lithium-containing glass ceramic, and the to-be-strengthened glass ceramic may include the following components in mole percentage:
Li₂O: 10% to 25%;
SiO₂: 58% to 72%;
Na₂O and K₂O: 3% to 7%;
Al₂O₃: 2% to 8%;
P₂O₅+ZrO₂+TiO₂: 2% to 13%;
MgO+CaO+ZnO: 0% to 3%; and
B₂O₃: 0% to 5%.

In this implementation of this application, SiO₂ is a main oxide forming a glass network, and provides a network structural strength for the glass. An SiO₂ content may be 60% to 72%, and further may be 65% to 70%. A higher SiO₂ content can enhance connectivity of a glass network structure, improve a density and a mechanical property of the glass.

In this implementation of this application, Li₂O and Na₂O are main constituents of ion exchange, and lithium ions are key exchange ions for performing the first step of ion exchange to form a sodium exchange layer. A higher Li₂O content may be used to obtain a deeper depth of the strengthening layer and a higher surface compressive stress through the first step of ion exchange, thereby improving an anti-crack generation capability and the drop resistance of the glass. However, if the Li₂O content is excessively high, a thermal expansion coefficient of the glass increases, heat impact resistance decreases, and the network structure is damaged. Therefore, in this embodiment of this application, the Li₂O content is controlled within a range of 10% to 25%. In some implementations, the Li₂O content is controlled within a range of 18% to 23%. In some other implementations, the Li₂O content is controlled within a range of 20% to 22%. The sodium ions are the key exchange ions for forming the outer potassium strengthening layer. The presence of K₂O can reduce a high-temperature viscosity and difficulty of melting, but excessive K₂O can reduce an ion exchange rate. Therefore, in this embodiment of this application, a total content of Na₂O and K₂O is controlled within a range of 3% to 5%. In some implementations, the total content of Na₂O and K₂O is controlled within 3.5% to 4.5%. In an implementation of this application, only Na₂O may be included, or both K₂O and Na₂O may be included.

In an implementation of this application, because a ratio of an oxide R₂O of an alkali metal R (where R is Li, Na, K, or the like) to Al₂O₃ is greater than 1 (mol%), and aluminum ions (Al³⁺) basically participate in the network structure of the glass in a tetrahedral form, as an Al₂O₃ content increases, the strength of the glass increases, and mechanical performance develops in a good direction. In addition, because a volume of a [AlO₄] tetrahedron is large, a network gap can be increased, and exchange ions can move more easily. Therefore, ion exchange performance can be improved. In some implementations of this application, the Al₂O₃ content may be 2% to 8%. In some other implementations, the Al₂O₃ content may be 3% to 6%. In some other implementations, the Al₂O₃ content may be 4% to 5%. In some implementations of this application, a total molar ratio of SiO₂ to Al₂O₃ is greater than or equal to 70%, so that stability of the glass network structure can be better ensured, and a strength of a glass body can be improved.

In an implementation of this application, the glass component further includes one or more of P₂O₅, ZrO₂, and TiO₂. As nucleating agents, P₂O₅, ZrO₂, and TiO₂ can crystallize inside the glass and microcrystallize the glass, thus enhancing the strength of the glass. However, excessive P₂O₅ leads to a decreased mechanical strength of the glass, especially a surface hardness, resulting in the glass very easy to be scratched. Excessive ZrO₂ leads to reduced devitrification resistance, and excessive TiO₂ leads to reduced devitrification resistance of the glass. Therefore, in this embodiment of this application, a total content of P₂O₅, ZrO₂, and TiO₂ is controlled within a range of 2% to 10%.

In some implementations of this application, the glass component may further include one or more of MgO, CaO, and ZnO. A total mass content of MgO, CaO and ZnO may be 1% to 3%, or 2% to 2.5%. As a network intermediate, MgO can improve a Young's modulus of the glass and toughness of the glass body, which is beneficial to improving drop resistance performance of entire electronic products. Moreover, the ion exchange performance of the glass may be improved and the high-temperature viscosity of the glass may be reduced. CaO may influence a melting temperature of the glass and make the glass network more dense. ZnO is an effective constituent to reduce a low-temperature viscosity of the glass, but excessive ZnO leads to phase separation and reduced devitrification resistance of the glass.

In some implementations of this application, the glass component may further include B₂O₃. B₂O₃ has good melting aid effect. However, because excessive B₂O₃ may damage a glass main network structure, water resistance and a mechanical strength are reduced. Therefore, in an implementation of this application, a B₂O₃ content is controlled within a range of 0% to 5%. In some implementations, the B₂O₃ content is controlled within a range of 1% to 4%. In some other implementations, the B₂O₃ content is controlled within a range of 2% to 3%.

In an implementation of this application, the to-be-strengthened glass ceramic includes a glass phase and a crystal phase. The crystal phase includes at least one of castorite, lithium silicate, and lithium disilicate.

In an implementation of this application, a total mass content of the crystal phase in the to-be-strengthened glass ceramic is greater than or equal to 50%. The crystal phase content represents crystallinity of the chemically strengthened glass ceramic. In some implementations, the total mass content of the crystal phase is greater than or equal to 60%. In some implementations, the total mass content of the crystal phase is greater than or equal to 70%. In some implementations, the total mass content of the crystal phase is 70% to 90%. In some implementations, the total mass content of the crystal phase is 80% to 88%. The content of the crystal phase may be determined by X-ray diffraction (X-ray diffraction, XRD).

In an implementation of this application, the thickness of the chemically strengthened glass ceramic 10 may be greater than or equal to 0.03 mm. In some implementations, the thickness of the chemically strengthened glass ceramic 10 may be greater than or equal to 0.04 mm. This may be specifically determined based on an application requirement. In some implementations, the thickness of the chemically strengthened glass ceramic 10 may be 0.4 mm to 1.5 mm. Specifically, the thickness of the chemically strengthened glass ceramic 10 may be, for example, but is not limited to, 0.4 mm, 0.5 mm, 0.6 mm, 0.7 mm, 0.8 mm, 0.9 mm, 1.0 mm, 1.1 mm, 1.2 mm, 1.3 mm, 1.4 mm, and 1.5 mm. A suitable thickness can not only ensure a high strength, but also meet an ultra-thin requirement of a cover product. The chemically strengthened glass ceramic may be a 2D chemically strengthened glass ceramic, a 2.5D chemically strengthened glass ceramic, or a 3D chemically strengthened glass ceramic.

In an implementation of this application, the chemically strengthened glass ceramic 10 has excellent optical properties, a high transmittance, and a low haze. Moreover, when the chemically strengthened glass ceramic is a 3D chemically strengthened glass ceramic, the chemically strengthened glass ceramic also has excellent optical properties. Specifically, an average transmittance of the chemically strengthened glass ceramic in an optical wavelength range of 400 nm to 700 nm is greater than or equal to 85%; a b value of a Lab color chromaticity indicator is greater than or equal to -2.0; and a haze is less than or equal to 0.25%. In some implementations, an average transmittance of the chemically strengthened glass ceramic whose thickness is greater than or equal to 0.4 mm in the optical wavelength range of 400 nm to 700 nm is greater than or equal to 85%; a b value of a Lab color chromaticity indicator is greater than or equal to -2.0; and a haze is less than or equal to 0.25%. In some implementations, the average transmittance of the chemically strengthened glass ceramic in the optical wavelength range of 400 nm to 700 nm is greater than or equal to 90%. In some implementations, the b value of the Lab color chromaticity indicator of the chemically strengthened glass ceramic 10 is greater than or equal to -1.5. In some implementations, the b value of the Lab color chromaticity indicator of the chemically strengthened glass ceramic 10 is greater than or equal to -0.4. In some implementations, the haze of the chemically strengthened glass ceramic 10 is less than or equal to 0.2%. In some implementations, the haze of the chemically strengthened glass ceramic 10 is less than or equal to 0.15%.

In an implementation of this application, the chemically strengthened glass ceramic has high dimensional stability, a length tolerance and a width tolerance within ±0.1 mm, and a CPK (Process Capability Index, process capability index) greater than or equal to 0.8. In some implementations, the length tolerance and the width tolerance are within ±0.1 mm, and the CPK is greater than or equal to 0.9. In some implementations, the length tolerance and the width tolerance are within ±0.1 mm, and the CPK is greater than or equal to 1.0.

In an implementation of this application, a Vickers hardness of the chemically strengthened glass ceramic is greater than or equal to 650 kgf/mm². In some implementations, the Vickers hardness of the chemically strengthened glass ceramic is greater than or equal to 720 kgf/mm². In some other implementations, the Vickers hardness of the chemically strengthened glass ceramic is greater than or equal to 730 kgf/mm².

The chemically strengthened glass ceramic in this embodiment of this application has good weather resistance and good drop resistance, and maintains good optical properties. Therefore, the glass ceramic can meet optical requirements of display and photographing of the display cover, the rear cover, and the camera protective cover of the electronic device, can also adapt to an extremely humid and hot use environment, and can further improve the reliability of the electronic device.

Correspondingly, an embodiment of this application provides a preparation method of the foregoing chemically strengthened glass ceramic. The method includes:
Step S101: Place a to-be-strengthened glass ceramic in a first salt bath to perform a first step of ion exchange, where a strengthening salt of the first salt bath includes a sodium salt whose mass fraction is greater than or equal to 30%.
Step S102: Place a to-be-strengthened glass ceramic obtained after the first step of ion exchange in a second salt bath to perform a second step of ion exchange to obtain the chemically strengthened glass ceramic, where a strengthening salt of the second salt bath includes a potassium salt whose mass fraction is greater than or equal to 85% and a lithium salt whose mass fraction is 0.005% to 1%.

The glass ceramic is strengthened by using the chemical strengthening process, and a depth of a potassium strengthening layer is controlled within 0.01 µm to 5 µm, so that good impact resistance strength can be maintained while the glass has good humid and hot environment resistance and rough ground drop resistance. Specifically, a proper quantity of lithium salts are added into the salt bath of the second step of ion exchange. The existence of the lithium salt in the salt bath may introduce a proper quantity of lithium ions into the glass in the second step of ion exchange, and the lithium ions have greater accumulation effect than the sodium ions. When the lithium ions enter a glass network, the glass network is more stable and a denser structure is formed. At the same time, the existence of the lithium salt may suppress ion exchange of a crystal phase in the glass and improve weather resistance of the glass. By using the foregoing strengthening process, when the depth of the potassium strengthening layer is increased to more than 5 µm, the impact resistance strength of the glass is unfavorable and the impact resistance strength is reduced. Therefore, the depth of the potassium strengthening layer is controlled to be 0.01 µm to 5 µm.

FIG. 5 is a stress curve diagram of a chemically strengthened glass ceramic according to an embodiment of this application and an aluminum-silicon one-time-strengthened glass (a one-time chemically strengthened aluminum-silicon non-ceramic glass) and a lithium-aluminum-silicon two-time-strengthened glass (namely, a secondary chemically strengthened lithium-aluminum-silicon non-ceramic glass) in the conventional technology. It can be learned from FIG. 5 that in this embodiment of this application, there is no obvious stress inflection point between the potassium strengthening layer and the sodium strengthening layer of the chemically strengthened glass ceramic, and there is no feature of a potassium strengthening layer of a conventional secondary strengthened aluminum-silicon glass. However, a strengthening layer is deep, and an overall compressive stress remains at a high level.

The first step of ion exchange is a first step of strengthening. In S101 of the foregoing preparation method, the first salt bath is a pure sodium salt bath or a mixed salt bath of a sodium salt and a potassium salt. In the mixed salt bath of the sodium salt and the potassium salt, a mass fraction of the sodium salt is not limited, for example, may be but is not limited to 30%, 40%, 50%, 60%, 70%, 80%, 90%, 95%, and 99%.

In some implementations, a temperature of the first step of ion exchange may be 380°C to 490°C. In some other implementations, the temperature of the first step of ion exchange may be 400°C to 480°C. In some implementations, a time period of the first step of ion exchange may be 3h to 24h. In some other implementations, the time period of the first step of ion exchange may be 6h to 20h.

The second step of ion exchange is a second step of strengthening. In S102 of the foregoing preparation method, the second salt bath is a mixed salt bath of a potassium salt and a lithium salt, or a mixed salt bath of a potassium salt, a lithium salt, and a sodium salt. In some implementations, a mass fraction of the lithium salt in the second salt bath is 0.1% to 0.5%. In some other implementations, the mass fraction of the lithium salt in the second salt bath is 0.55% to 1%. In some other implementations, the mass fraction of the lithium salt in the second salt bath is 0.6% to 1%. Lithium ions can better enter a glass network when a concentration of the lithium salt is high, to improve a density of the glass, and improve humidity and heat resistance of the glass. Addition of the lithium salt with potassium ion exchange helps to form a stable protective layer on a surface of the glass ceramic, to suppress corrosion of the glass caused by sodium salt precipitation of a strengthened glass ceramic in a high-temperature and high-humidity process. That a LiNO₃ content is 0.005% to 1% plays an important role. If the content is very low, suppression effect of the sodium salt is poor. If the content is very high, a stress decreases too much and an impact resistance strength decreases. A mass fraction of the potassium salt in the second salt bath may be, for example, but not limited to, 85%, 90%, 95%, and 99%. The lithium salt may be, for example, LiNO₃.

In some implementations, a temperature of the second step of ion exchange may be 370°C to 450°C. In some other implementations, the temperature of the second step of ion exchange may be 380°C to 420°C. In some implementations, a time period of the second step of ion exchange may be 2 mins to 240 mins. In some other implementations, the time period of the second step of ion exchange may be 10 mins to 200 mins.

In some implementations of this application, the foregoing preparation method further includes:
before placing the to-be-strengthened glass ceramic in the first salt bath to perform the first step of ion exchange, preheating the to-be-strengthened glass ceramic at 150°C to 480°C for 5 mins to 300 mins. The preheating operation before strengthening can improve subsequent strengthening effect.

In some implementations of this application, the foregoing preparation method further includes:
after performing the first step of ion exchange on the to-be-strengthened glass ceramic and before performing the second step of ion exchange, first immersing a to-be-strengthened glass ceramic obtained after the first step of ion exchange in hot water at 30°C to 60°C for 10 mins to 60 mins, or immersing the to-be-strengthened glass ceramic in the abandoned second salt bath for 1 min to 60 mins. This operation can avoid impact caused by a residual first salt bath constituent on an ion concentration of the second salt bath on a surface of the glass ceramic.

In general, chemical strengthening for the glass ceramic is carried out after forming. In an implementation of this application, the to-be-strengthened glass ceramic may be a to-be-strengthened 2D glass ceramic, a to-be-strengthened 2.5D glass ceramic, or a to-be-strengthened 3D glass ceramic.

In this implementation of this application, the to-be-strengthened 3D glass ceramic may be prepared in the following manner:
accommodating a glass ceramic raw material in a forming mold, and sequentially performing a preheating process, a forming process, a crystallization process, and an annealing cooling process to obtain the to-be-strengthened 3D glass ceramic, where crystallinity of the glass ceramic raw material is 5% to 75%, and a temperature of the crystallization process is greater than or equal to a temperature of the forming process.

According to this embodiment of this application, 3D hot bending forming is performed on the glass ceramic raw material having medium crystallinity (5% to 75%), and the crystallization process is introduced into the hot bending forming process for further crystallization of the glass, to finally complete partial or entire crystallization. In this way, the to-be-strengthened 3D glass ceramic with high crystallinity may be finally obtained through preparation, so that the 3D glass ceramic has both excellent optical properties and good drop resistance. In addition, 3D forming efficiency can be improved, a yield rate of 3D forming products is improved, and good dimensional stability is obtained.

The to-be-strengthened 3D glass ceramic prepared in this embodiment of this application has the high crystallinity, and includes a crystal phase greater than or equal to 50%. That is, the crystallinity is greater than or equal to 50%. The specific crystallinity may be controlled based on an actual requirement. In some implementations, a total mass content of the crystal phase is greater than or equal to 60%. In some implementations, the total mass content of the crystal phase is greater than or equal to 70%. In some implementations, the total mass content of the crystal phase is 70% to 90%. In some implementations, the total mass content of the crystal phase is 80% to 88%. The to-be-strengthened 3D glass ceramic in this embodiment of this application has excellent optical properties, a high visible light transmittance, and a low haze. Specifically, an average transmittance of the to-be-strengthened 3D glass ceramic in an optical wavelength range of 400 nm to 700 nm is greater than or equal to 85%; a b value of a Lab color chromaticity indicator is greater than or equal to -2.0; and a haze is less than or equal to 0.25%. In some implementations, an average transmittance of the to-be-strengthened 3D glass ceramic whose thickness is greater than or equal to 0.4 mm in the optical wavelength range of 400 nm to 700 nm is greater than or equal to 85%; a b value of a Lab color chromaticity indicator is greater than or equal to -2.0; and a haze is less than or equal to 0.25%. In some implementations, the average transmittance of the to-be-strengthened 3D glass ceramic in the optical wavelength range of 400 nm to 700 nm is greater than or equal to 90%. In some implementations, the b value of the Lab color chromaticity indicator of the to-be-strengthened 3D glass ceramic is greater than or equal to -1.5. In some implementations, the b value of the Lab color chromaticity indicator of the to-be-strengthened 3D glass ceramic is greater than or equal to -0.4. In some implementations, the haze of the to-be-strengthened 3D glass ceramic is less than or equal to 0.2%. In some implementations, the haze of the to-be-strengthened 3D glass ceramic is less than or equal to 0.15%. In an implementation of this application, a Vickers hardness of the to-be-strengthened 3D glass ceramic is greater than or equal to 650 kgf/mm².

A 3D glass ceramic cover obtained by using the foregoing hot bending process has high dimensional stability, a length tolerance and a width tolerance within ±0.1 mm, and a CPK (Process Capability Index, process capability index) greater than or equal to 0.8, and can reach a level of a common lithium-aluminum-silicon glass. In some implementations, the length tolerance and the width tolerance are within ±0.1 mm, and the CPK is greater than or equal to 0.9. In some implementations, the length tolerance and the width tolerance are within ±0.1 mm, and the CPK is greater than or equal to 1.0.

In an implementation of this application, the crystallinity of the glass ceramic raw material is 5% to 75%. The glass ceramic raw material having the medium crystallinity may be used to prevent the glass from being broken because the glass is difficult to be hot bent due to excessively high crystallinity, prevent optical property deterioration caused by excessive crystal growth, and avoid problems of poor dimensional stability and poor drop resistance caused by excessively low crystallinity. In some implementations of this application, the crystallinity of the glass ceramic raw material may be 5% to 65%. In some other implementations, the crystallinity of the glass ceramic raw material may be 10% to 50%. In some other implementations, the crystallinity of the glass ceramic raw material may be 15% to 40%, and 20% to 30%. The crystallinity of the glass ceramic raw material is very low and volume shrinkage effect is large. This is not conducive to improving the dimensional stability. A risk of breakage of the glass is increased because the crystallinity is very high, and the optical property is deteriorated due to excessive crystal growth.

In an implementation of this application, the glass ceramic raw material is a flat glass ceramic raw material. The glass ceramic raw material may be prepared by a calendering method, a casting method, and the like. A composition constituent of the glass ceramic raw material is the same as that of the to-be-strengthened glass ceramic. The constituent of the glass ceramic raw material may be obtained by using an electron probe micro-analysis or a scanning electron microscope in combination with an X-ray energy dispersive spectrometer (EDS, Energy Dispersive Spectrometer). A thickness of the glass ceramic raw material may be specifically selected based on an application requirement.

The preheating process, the forming process, the crystallization process and the annealing cooling process are all completed in a hot bending device.

In an implementation of this application, in the preheating process, a forming mold accommodating the glass ceramic raw material passes through a preheating station of the hot bending device. In the preheating process, a plurality of preheating stations may be passed through. The temperature during the preheating process is within a range of 0°C to 780°C. The temperature may also be within a range of 0°C to 680°C. A temperature of a preheating station that is passed through first is less than or equal to a temperature of a preheating station that is passed through later. In some implementations, each preheating station has a different temperature, and the temperature of each preheating station is gradually increased in an order of being successively passed through. The gradual increase may be a gradient increase or a non-gradient increase. A retention time period in each preheating station may be 20s to 200s. In some implementations, at least four preheating stations are passed through in the preheating process. In an implementation of this application, in the preheating process, the forming mold accommodating the glass ceramic raw material sequentially passes through a first preheating station, a second preheating station, a third preheating station, a fourth preheating station, a fifth preheating station, and a sixth preheating station. Temperatures of the first preheating station, the second preheating station, the third preheating station, the fourth preheating station, and the fifth preheating station are within a range of 300°C to 700°C, and a temperature of the sixth preheating station is within a range of 650°C to 780°C.

In an implementation of this application, in the forming process, the forming mold accommodating the glass ceramic raw material passes through a forming station of the hot bending device. In the forming process, one or more forming stations may be passed through. A temperature of the forming process is within a range of 600°C to 850°C. In some implementations, a temperature of the forming station is within a range of 700°C to 850°C. A temperature of a forming station that is passed through first is less than or equal to a temperature of a forming station that is passed through later. In some implementations, temperatures of the forming stations may be the same or different. A retention time period in each forming station may be 20s to 100s. In some implementations, at least two forming stations are passed through in the forming process. A forming pressure in the forming process is 0 MPa to 0.9 MPa. The forming pressure refers to a pressure applied to the forming mold when the forming mold accommodating the glass ceramic raw material is placed in the forming station. In some implementations, the forming pressure of the forming station may be 0.001 Mpa to 0.9 Mpa. In some other implementations, the forming pressure of the forming station may be 0.1 Mpa to 0.9 Mpa. In a specific implementation of this application, in the forming process, two forming stations are successively passed through. In another specific implementation of this application, in the forming process, three forming stations are successively passed through.

In an implementation of this application, in the crystallization process, the forming mold accommodating the glass ceramic raw material passes through a crystallization station of the hot bending device. In the crystallization process, one or more crystallization stations may be passed through. A temperature of the crystallization station is greater than or equal to the temperature of the forming station. The temperature of the crystallization station is greater than or equal to the temperature of the forming station, so that the glass ceramic raw material can be further crystallized during the crystallization process, and finally the to-be-strengthened 3D glass ceramic with high crystallinity is obtained. The temperature of the crystallization process is within a range of 700°C to 900°C. A retention time period of the glass ceramic raw material in each crystallization station may be 20s to 100s. A pressure may also be applied during the crystallization process. In some implementations, at least two crystallization stations are passed through in the crystallization process. In an implementation of this application, a temperature of a crystallization station that the glass ceramic raw material passes through later may be less than or equal to a temperature of a crystallization station that the glass ceramic raw material passes through first. This facilitates the transition to a next step, namely, the annealing cooling process.

In an implementation of this application, in the annealing cooling process, the forming mold accommodating the glass ceramic raw material passes through an annealing cooling station of the hot bending device. In the annealing cooling process, one or more annealing cooling stations may be passed through. A temperature of the annealing cooling process may be within a range of 0°C to 800°C. In some implementations, at least two annealing cooling stations are passed through in the annealing cooling process. A temperature of an annealing cooling station that is passed through first is greater than or equal to a temperature of an annealing cooling station that is passed through later. A retention time period of the glass ceramic raw material in each annealing cooling station may be 20s to 200s. In some implementations, a plurality of annealing cooling stations have different temperatures, and in particular, the temperatures may be gradually decreased in an order of being successively passed through. The gradual decrease may be a gradient decrease or a non-gradient decrease. In a specific implementation of this application, in the annealing cooling process, four annealing cooling stations are successively passed through. Temperatures of three annealing cooling stations that are passed through first are within in a range of 300°C to 700°C, and a temperature of the last annealing cooling station is at a room temperature to 500°C. In an implementation of this application, each cooling station may use water cooling, or may use air cooling, namely, air cooling. In a specific implementation, the three annealing cooling stations that are passed through first use water cooling, a retention time period in each cooling station is 20 seconds to 200 seconds; and the fourth cooling station uses air cooling, and a retention time period in the fourth cooling station is greater than or equal to 100 seconds.

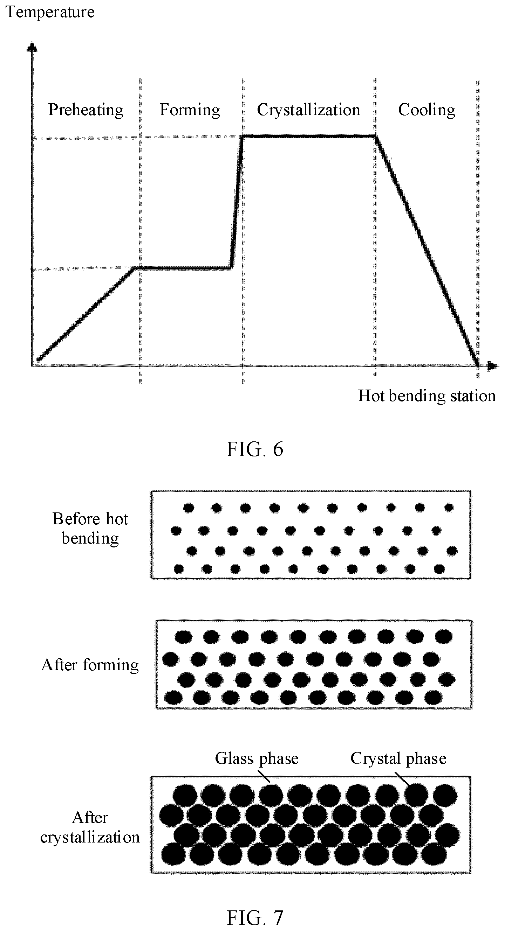

FIG. 6 is a temperature curve diagram of four types of hot bending stations of a preheating station, a forming station, a crystallization station, and an annealing cooling station of a hot bending device in sequence when a forming mold accommodating a glass ceramic raw material according to an embodiment of this application. FIG. 7 is a schematic diagram of crystal phase changes inside a glass ceramic raw material in different heat treatment stages in a hot bending forming process according to an embodiment of this application. As can be seen from the figure, after a crystallization process of the hot bending forming process is completed, a crystal phase inside the glass has grown well.

The foregoing preparation process of this application has low requirements on a hot bending device, and a 3D glass ceramic with excellent mechanical properties, optical properties, high crystallinity, and an excellent dimension can be obtained in one hot bending forming process, and has great advantages in a hot bending yield, efficiency, and the like of the glass ceramic. According to the embodiment of this application, 3D hot bending forming is performed on a glass ceramic raw material having medium crystallinity (5% to 75%), and a crystallization process is introduced after the forming process to prepare a 3D glass ceramic. In this way, a glass ceramic with high crystallinity may be finally obtained, and has both excellent optical properties and good drop resistance. In addition, 3D forming efficiency can be improved, a yield rate of 3D forming products is improved, and good dimensional stability is obtained.

In some implementations of this application, the glass ceramic used in the electronic device 100 is a 3D glass ceramic. In some implementations, the 3D glass ceramic is the to-be-strengthened 3D glass ceramic described above in this application. Details are not described herein again. An average transmittance of the 3D glass ceramic in an optical wavelength range of 400 nm to 700 nm is greater than or equal to 85%; a b value of a Lab color chromaticity indicator is greater than or equal to -2.0; a haze is less than or equal to 0.25%; and a process capability index CPK of the 3D glass ceramic with a length tolerance and a width tolerance within ±0.1 mm is greater than or equal to 0.8. The 3D glass ceramic has excellent optical properties, a high visible light transmittance, and a low haze, and also has high dimensional stability and a high product yield.

In an implementation of this application, the 3D glass ceramic includes a chemically strengthened 3D glass ceramic, and a compressive stress layer is on a surface of the chemically strengthened 3D glass ceramic. In some implementations, the chemically strengthened 3D glass ceramic is the chemically strengthened glass ceramic described above in this application. In some other implementations, the compressive stress layer of the chemically strengthened 3D glass ceramic may be different from the strengthening layer of the chemically strengthened glass ceramic previously described in this application.

An embodiment of this application further provides a preparation method of a 3D glass ceramic. The method includes:
accommodating a glass ceramic raw material in a forming mold, and sequentially performing a preheating process, a forming process, a crystallization process, and an annealing cooling process to obtain the 3D glass ceramic, where crystallinity of the glass ceramic raw material is 5% to 75%, and a temperature of the crystallization process is greater than or equal to a temperature of the forming process. Specifically, the process for preparing the to-be-strengthened 3D glass ceramic is described above. Details are not described herein again. According to the preparation method of the 3D glass ceramic according to the embodiment of this application, 3D hot bending forming is performed on the glass ceramic raw material having medium crystallinity (5% to 75%), and the crystallization process is introduced after the forming process to prepare the 3D glass ceramic. In this way, a glass ceramic with high crystallinity may be finally obtained, and has both excellent optical properties and good drop resistance. In addition, 3D forming efficiency can be improved, a yield rate of 3D forming products is improved, and good dimensional stability is obtained.

In an implementation of this application, when the 3D glass ceramic is a chemically strengthened 3D glass ceramic, the foregoing preparation method further includes: performing strengthening by using a strengthening process after annealing and cooling. The strengthening process may be as described above, or another available strengthening process may be used.

The following further describes this embodiment of this application by using a plurality of embodiments by using an example in which a glass cover of a mobile phone is prepared.

### Embodiment 1

(1) A glass raw material is prepared by using a melting cooling method to keep a temperature at 1500°C to 1700°C for 2 h to 24 h. Composition of the glass raw material is 15% Li₂O-8% Al₂O₃-72% SiO₂-0.5% ZrO₂-1.5% P₂O₅-1% Na₂O-2% K₂O.
(2) The prepared glass raw material is sequentially kept at 400°C to 520°C for 0.5 hours to 10 hours, at 520°C to 640°C for 0.5 hours to 10 hours, and at 640°C to 750°C for 0.1 hours to 10 hours, and then annealed to obtain the glass ceramic raw material. Molar composition of the glass ceramic raw material is 15% Li₂O-8% Al₂O₃-72% SiO₂-0.5% ZrO₂-1.5% P₂O₅-1% Na₂O-2% K₂O, a crystal phase includes lithium silicate and quartz, and the crystallinity is 50%.
(3) The obtained glass ceramic raw material is cut by a diamond wire, and then both sides of the glass ceramic raw material are polished to a thickness of 0.65 mm by using a grinding process, and then the glass cover of the mobile phone with a required shape and a required size is prepared by using a mobile phone cover processing process.
(4) Chemical strengthening is performed on the obtained glass cover of the mobile phone to obtain a strengthened glass cover of the mobile phone. A molten salt in a first step of strengthening is a strengthening salt containing 50% NaNO₃-50% KNO₃, a strengthening temperature is 380°C to 490°C, and a strengthening time period is 3h to 24h. A molten salt in a second step of strengthening is a strengthening salt containing 85% KNO₃-14% NaNO₃-1% LiNO₃, a strengthening temperature is 370°C to 450°C, and a strengthening time period is 2 mins to 240 mins.

### Embodiment 2

The only difference from Embodiment 1 lies in that a glass raw material of this embodiment has components of 25% Li₂O-2% Al₂O₃-60% SiO₂-2% ZrO₂-3% P₂O₅ -4% Na₂O-1% K₂O-5% B₂O₃. Molar composition of a glass ceramic matrix is 25% Li₂O-2% Al₂O₃-60% SiO₂-2% ZrO₂-3% P₂O₅ -4% Na₂O-1% K₂O-5% B₂O₃, a crystal phase includes lithium disilicate and castorite, and crystallinity is 75%. Different chemical strengthening processes are used in this embodiment. For details, refer to Table 1.

### Embodiment 3

The only difference from Embodiment 1 lies in that different chemical strengthening processes are used. For details, refer to Table 1.

### Embodiment 4

The only difference from Embodiment 2 lies in that different chemical strengthening processes are used. For details, refer to Table 1.

### Embodiment 5

The only difference from Embodiment 1 lies in that a glass raw material of this embodiment has components of 20% Li₂O-3% Al₂O₃-60% SiO₂-6% ZrO₂-3% PzOs-1 TiO₂-3% Na₂O-1% K₂O-1% MgO-1% CaO-1% ZnO. Molar composition of a glass ceramic matrix is 20% Li₂O-3% Al₂O₃-60% SiO₂-6% ZrO₂-3% PzOs-1 TiO₂-3% Na₂O-1% K₂O-1% MgO-1% CaO-1% ZnO, a crystal phase includes lithium disilicate and castorite, and crystallinity is 90%. Different chemical strengthening processes are used in this embodiment. For details, refer to Table 1.

### Embodiment 6

The only difference from Embodiment 5 lies in that different chemical strengthening processes are used. For details, refer to Table 1.

### Comparative example 1

The only difference from Embodiment 1 lies in that different chemical strengthening processes are used. For details, refer to Table 1.

### Comparative example 2

The only difference from Embodiment 2 lies in that different chemical strengthening processes are used. For details, refer to Table 1.

A glass stress tester is used to perform a stress test on a glass cover of a mobile phone prepared in Embodiment 1 to Embodiment 6 and Comparative example 1 and Comparative example 2. Test results are shown in Table 1.

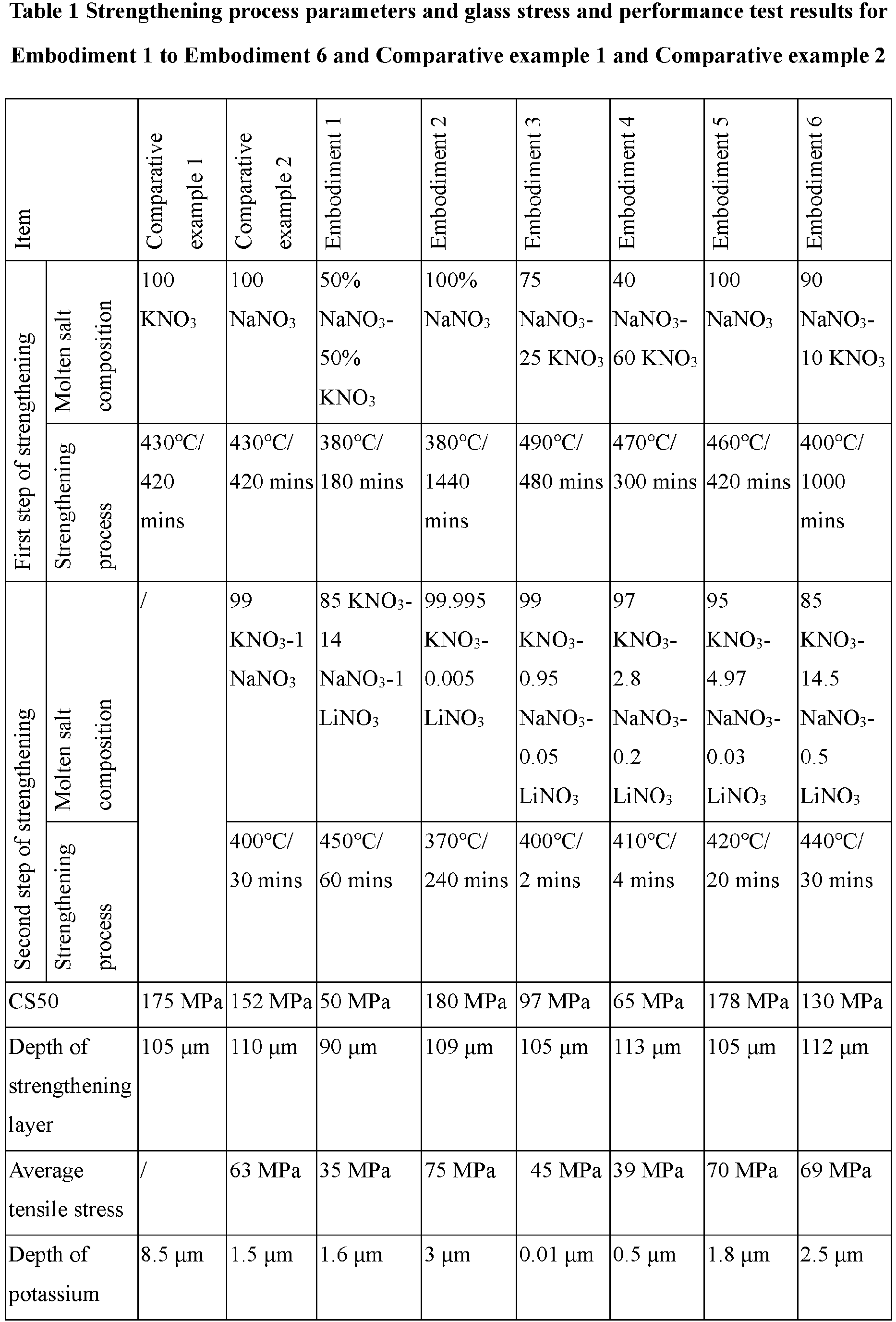

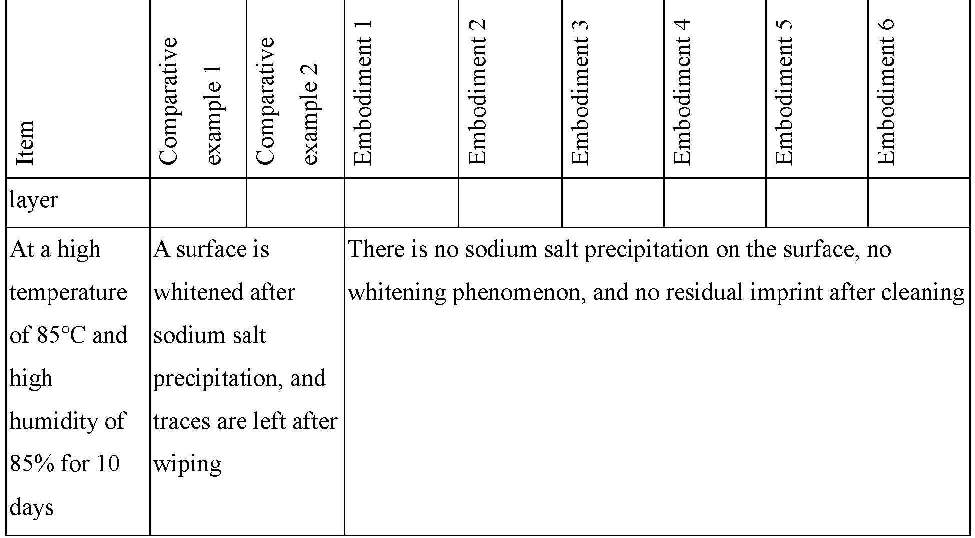

It can be learned from the results in Table 1 that the strengthened glass cover of the mobile phone obtained by using the chemical strengthening process provided in this embodiment of this application may implement high-level chemical strengthening, a CS50 after strengthening is greater than or equal to 50 Mpa, and the depth Doc of the strengthened layer is greater than or equal to 90 µm. Therefore, the glass cover has a high strength, and a high drop resistance height can be obtained. The glass cover of the mobile phone in Embodiment 1 to Embodiment 6 is used, and a drop resistance height of the whole device is greater than or equal to 1.5m in a scenario of 200g 180# sandpaper. The glass cover of the mobile phone in Embodiment 1 to Embodiment 6 has an anti-falling ball impact strength greater than 0.15J. At the same time, the glass cover of the mobile phone in Embodiment 1 to Embodiment 6 has strong weather resistance, and no residual corrosion imprint occurs when the glass cover is stored in a humid and hot environment with 85°C temperature/85% humidity for 240h. In Embodiment 1 to Embodiment 6 of this application, a strengthening salt of 0.005% to 1% LiNO₃ is introduced into the molten salt in the second step of strengthening, and a thickness of the potassium strengthening layer is controlled within 0.01 µm to 5 µm. The glass ceramic can maintain excellent impact resistance and drop resistance while having excellent high-temperature and high-humidity environment resistance.

### Embodiment 7

(1) A glass raw material is prepared by using a melt cooling method to keep a temperature at 1500°C to 1700°C for 2 h to 24 h, where constituent composition of the glass is as follows: 20% Li₂O-2% Al₂O₃-58% SiO₂-5% ZrO₂-8% P₂O₅-5% Na₂O-2% K₂O.
(2) The prepared glass raw material is sequentially kept at 400°C to 520°C for 0.5 h to 1 h and at 580°C to 640°C for 5 h, to obtain a glass ceramic raw material whose crystallinity is 65% and whose crystal phase is lithium silicate and castorite.
(3) The obtained glass ceramic raw material is cut by a diamond wire, then ground to a thickness of 0.65 mm by using a grinding process, and polished on both sides; and then a required 3D glass ceramic cover of the mobile phone is obtained through hot bending with a temperature system listed in Table 2.
(4) Chemical strengthening is performed on the obtained 3D glass ceramic cover of the mobile phone to obtain a strengthened 3D glass ceramic cover of the mobile phone. A molten salt in a first step of strengthening contains 40 wt% to 100 wt% NaNO₃ and 0 to 60 wt% KNO₃, a strengthening temperature is 380°C to 490°C, and a strengthening time period is 3 hours to 24 hours. A molten salt in a second step of strengthening is a strengthening salt containing more than or equal to 85 wt% KNO₃ and 0.005 wt% to 1wt% LiNO₃, a strengthening temperature is 370°C to 450°C, and a strengthening time period is 2 mins to 240 mins.

### Embodiment 8

The only difference from Embodiment 7 lies in that temperature systems during hot bending in step (3) are different. For details, refer to Table 2.

### Embodiment 9

(1) A glass raw material is prepared by using a melt cooling method to keep a temperature at 1500°C to 1700°C for 2 h to 24 h, where constituent composition of the glass is as follows: 20% Li₂O-2% Al₂O₃-58% SiO₂-5% ZrO₂-8% P₂O₅-5% Na₂O-2% K₂O.
(2) The prepared glass raw material is kept at 400°C to 520°C for 0.5 h to 1 h, to obtain a glass ceramic raw material whose crystallinity is 5% and whose crystal phase is lithium silicate/castorite.
(3) The obtained glass ceramic raw material is cut by a diamond wire, then ground to a thickness of 0.65 mm by using a grinding process, and polished on both sides; and then a required 3D glass ceramic cover of the mobile phone is obtained through hot bending with a temperature system listed in Table 2.
(4) Chemical strengthening is performed on the obtained 3D glass ceramic cover of the mobile phone to obtain a strengthened 3D glass ceramic cover of the mobile phone. A molten salt in a first step of strengthening contains 40 wt% to 100 wt% NaNO₃ and 0 to 60 wt% KNO₃, a strengthening temperature is 380°C to 490°C, and a strengthening time period is 3 hours to 24 hours. A molten salt in a second step of strengthening is a strengthening salt containing more than or equal to 85 wt% KNO₃ and 0.005 wt% to 1wt% LiNO₃, a strengthening temperature is 370°C to 450°C, and a strengthening time period is 2 mins to 240 mins.

### Embodiment 10

The only difference from Embodiment 9 lies in that temperature systems during hot bending in step (3) are different. For details, refer to Table 2.

### Embodiment 11 to Embodiment 14

The only difference from Embodiment 7 lies in that glass ceramic raw materials with different crystallinity are obtained by adjusting process parameters such as a temperature and a time period in step (1) and step (2). For the specific crystallinity, refer to crystallinity of a raw material in Table 3.

### Comparative example 3

The only difference from Embodiment 7 is that a glass ceramic raw material with crystallinity greater than 85% is subject to a hot bending process in Table 2.

### Comparative example 4

The only difference from Embodiment 9 is that a glass ceramic raw material with crystallinity of 0% is subj ect to a hot bending process in Table 2, and then placed in a crystallization furnace at 650°C for 4 h, to obtain a crystallized glass sample.

**Table 2 hot bending temperature/pressure system for Embodiment 7 to Embodiment 10 and Comparative example 3 and Comparative example 4**

| Cases | | Preheating process/°C | | | | | | Molding process/°C | | | Crystallization process/°C | | Annealing cooling process/°C | | |
|---|---|---|---|---|---|---|---|---|---|---|---|---|---|---|---|
| | | 1 | 2 | 3 | 4 | 5 | 6 | 1 | 2 | 3 | 1 | 2 | 1 | 2 | 3 |
| Comparative example 3 | Temperature (°C) | 700 | 710 | 720 | 730 | 740 | 750 | 780 | 780 | 780 | / | / | 650 | 600 | 500 |
| | Pressure (Mpa) | 0 | 0 | 0 | 0 | 0 | 0 | 0.5 | 0.3 | 0.3 | / | / | 0 | 0 | 0 |
| Comparative example 4 | Temperature (°C) | 570 | 580 | 590 | 600 | 600 | 610 | 610 | 620 | 620 | / | / | 600 | 550 | 450 |
| | Pressure (Mpa) | 0 | 0 | 0 | 0 | 0 | 0 | 0.5 | 0.3 | 0.1 | / | / | 0 | 0 | 0 |
| Embodiment 7 | Temperature (°C) | 600 | 610 | 620 | 630 | 650 | 730 | 730 | 740 | / | 750 | / | 650 | 600 | 500 |
| | Pressure (Mpa) | 0 | 0 | 0 | 0 | 0 | 0 | 0.5 | 0.3 | / | 0.1 | / | 0 | 0 | 0 |
| Embodiment 8 | Temperature (°C) | 600 | 610 | 620 | 630 | 650 | 660 | 750 | 760 | / | 780 | / | 650 | 600 | 500 |
| | Pressure (Mpa) | 0 | 0 | 0 | 0 | 0 | 0 | 0.5 | 0.3 | / | 0 | / | 0 | 0 | 0 |
| Embodiment 9 | Temperature (°C) | 600 | 620 | 630 | 670 | / | / | 680 | 680 | 700 | 760 | 760 | 600 | 550 | 450 |
| | Pressure (Mpa) | 0 | 0 | 0 | 0 | / | / | 0.55 | 0.55 | 0.01 | 0.01 | 0.01 | 0 | 0 | 0 |
| Embodiment 10 | Temperature (°C) | 570 | 580 | 590 | 600 | / | / | 600 | 610 | / | 780 | 760 | 600 | 550 | 450 |
| | Pressure (Mpa) | 0 | 0 | 0 | 0 | / | / | 0.55 | 0.55 | / | 0 | 0 | 0 | 0 | 0 |

3D glass ceramic covers of the mobile phone prepared in Embodiment 7 to Embodiment 14 and Comparative example 3 and Comparative example 4 are tested for optical properties, hardness, dimensional stability, and crystallinity, and results are shown in Table 3. CPK dimension data is test data of 32 samples collected corresponding to glass samples.

**Table 3 Performance test results for the glass samples of Embodiment 7 to Embodiment 14 and Comparative example 3 and Comparative example 4**

| Cases | Optical properties: | | | Vickers hardness (kgf/mm²) | Dimensional stability | Crystallinity of raw material (wt%) | Crystallinity of 3D cover (wt%) |
|---|---|---|---|---|---|---|---|
| | Average transmittance (at 400 nm to 700 nm) | b value of a Lab color chromatic ity indicator | Haze | | CPK (±0.1 mm tolerance) | | |
| Comparative example 3 | 83.4% | -3.7 | 0.40% | 710 | 0.92 | > 85% | > 85% |
| Comparative example 4 | 85.3% | -1.5 | 0.35% | 720 | 0.32 | 0% | > 85% |
| Embodiment 7 | 91.2% | -0.15 | 0.12% | 735 | 0.96 | 65% | > 85% |
| Embodiment 8 | 88.5% | -1.2 | 0.22% | 740 | 0.92 | 65% | > 85% |
| Embodiment 9 | 90.2% | -0.3 | 0.15% | 730 | 0.87 | 5% | > 85% |
| Embodiment 10 | 87.9% | -0.5 | 0.18% | 725 | 1.02 | 5% | > 85% |
| Embodiment 11 | 89.8% | -0.38 | 0.20% | 725 | 0.12 | 3% | > 85% |
| Embodiment 12 | 90.5% | -0.21 | 0.17% | 720 | 0.81 | 30% | > 85% |
| Embodiment 13 | 89.0% | -0.43 | 0.23% | 723 | 0.87 | 50% | > 85% |

| Average transmittance (at 400 nm to 700 nm) | b value of a Lab color chromatic ity indicator | Haze | CPK (±0. 1 mm tolerance) | | | | |
|---|---|---|---|---|---|---|---|
| Embodiment 14 | 84.0% | -2.2 | 0.45% | 750 | 1.14 | 82% | > 85% |

It can be learned from Table 3 that a high degree of crystallinity (where the crystallinity is greater than or equal to 70%) can be achieved by using the 3D hot bending forming process provided in embodiments of this application, and excellent optical properties and good dimensional stability can be obtained. The average transmittance of the 3D glass ceramic cover in the optical wavelength range of 400 nm to 700 nm is greater than or equal to 85%; the b value of the Lab color chromaticity indicator is greater than or equal to -1.5; and the haze is less than or equal to 0.25%. The length tolerance and the width tolerance of the 3D glass ceramic cover is ±0.1 mm, and the CPK is greater than or equal to 0.8. According to the 3D hot bending forming process provided in embodiments of this application, a glass ceramic raw material with medium crystallinity is used as a raw material. In this way, a hot bending breaking rate can be reduced, and an excessively large grain can be prevented, to obtain good optical properties. In addition, dimensional stability of hot bending forming can be ensured, and a required main crystal phase can be obtained. In the process, the crystallization process is introduced into the hot bending process, so that the glass enters a high-temperature crystallization process after hot bending forming is completed. In this way, crystallinity of the glass can be improved and good drop resistance can be obtained. In addition, the hot bending forming process has low requirements on a hot bending device, a high hot bending yield, and high hot bending efficiency. In Comparative example 3, the glass raw material with high crystallinity is used for hot bending, and in order to achieve a viscosity suitable for hot bending, a higher preheating temperature is required, and in a high-temperature preheating process, micro-crystals grow inside the glass ceramic, which easily causes the glass to turn blue and the optical properties becomes poor. Moreover, nano-crystallites grow, a microcrack increases, the crystallinity becomes higher, and the glass is easy to break in the hot bending process, to damage a mold, so that a yield is low. In addition, a higher internal temperature of the hot bending device results in uneven spatial distribution of a temperature field, resulting in different grain sizes and a color difference at different positions of the same glass. However, in Comparative example 4, the glass ceramic raw material with lower crystallinity is selected, and the crystallization operation is performed after hot bending is completed. Forming and crystallization in the scheme are performed separately, and efficiency is low. In addition, there is large volume shrinkage during crystallization, and there is a gap between the hot bending mold and the 3D glass. This inevitably leads to dimensional instability during crystallization. Moreover, the scheme has a high requirement on a crystallization furnace, needs a protective atmosphere and a pressurization device, and has high technical requirements on devices and high costs.

It may also be learned from Embodiment 11 and Embodiment 14 that, when a glass ceramic raw material whose crystallinity is less than 5% is selected for hot bending by using the hot bending process in embodiments of this application, dimensional stability of the glass cover product is poor. However, when hot bending is performed by using a glass ceramic raw material whose crystallinity is higher than 75% by using the hot bending process in embodiments of this application, optical properties of the glass cover product significantly deteriorates.

## Claims

1. A chemically strengthened glass ceramic, wherein strengthening layers are respectively formed on opposite sides of the chemically strengthened glass ceramic, and the strengthening layer comprises a potassium strengthening layer and a sodium strengthening layer sequentially from a surface to an inside of the chemically strengthened glass ceramic, wherein a depth of the potassium strengthening layer is 0.01 µm to 5 µm, and a depth of the sodium strengthening layer is greater than or equal to 0.1t, wherein t is a thickness of the chemically strengthened glass ceramic.

2. The chemically strengthened glass ceramic according to claim 1, wherein a depth of the strengthening layer is greater than or equal to 80 µm.

3. The chemically strengthened glass ceramic according to claim 1 or 2, wherein a compressive stress CS50 of the chemically strengthened glass ceramic at a depth of 50 µm of the strengthening layer is greater than or equal to 50 MPa.

4. The chemically strengthened glass ceramic according to any one of claims 1 to 3, wherein an average tensile stress of the chemically strengthened glass ceramic is 35 MPa to 85 MPa.

5. The chemically strengthened glass ceramic according to any one of claims 1 to 4, wherein a concentration of a sodium element decreases monotonically in a thickness range of 0.01t to 0.1t from the surface to the inside of the chemically strengthened glass ceramic.

6. The chemically strengthened glass ceramic according to any one of claims 1 to 5, wherein the chemically strengthened glass ceramic is maintained at a temperature of 85°C and a humidity of 85% for 120 hours or more, and no white sodium-containing compound is precipitated on the surface.

7. The chemically strengthened glass ceramic according to any one of claims 1 to 6, wherein the chemically strengthened glass ceramic is obtained by chemically strengthening a to-be-strengthened glass ceramic, and the to-be-strengthened glass ceramic comprises the following components in mole percentage:
Li₂O: 10% to 25%;
SiO₂: 58% to 72%;
Na₂O and K₂O: 3% to 7%;
Al₂O₃: 2% to 8%;
P₂O₅+ZrO₂+TiO₂: 2% to 13%;
MgO+CaO+ZnO: 0% to 3%; and
B₂O₃: 0% to 5%.

8. The chemically strengthened glass ceramic according to claim 7, wherein the to-be-strengthened glass ceramic comprises a glass phase and a crystal phase, and the crystal phase comprises at least one of castorite, lithium silicate, and lithium disilicate.

9. The chemically strengthened glass ceramic according to claim 8, wherein a total mass content of the crystal phase in the to-be-strengthened glass ceramic is greater than or equal to 50%.

10. The chemically strengthened glass ceramic according to any one of claims 1 to 9, wherein the chemically strengthened glass ceramic comprises a 2D chemically strengthened glass ceramic, a 2.5D chemically strengthened glass ceramic, or a 3D chemically strengthened glass ceramic.

11. The chemically strengthened glass ceramic according to any one of claims 1 to 10, wherein the thickness of the chemically strengthened glass ceramic is greater than or equal to 0.03 mm.

12. The chemically strengthened glass ceramic according to any one of claims 1 to 11, wherein an average transmittance of the chemically strengthened glass ceramic in an optical wavelength range of 400 nm to 700 nm is greater than or equal to 85%; a b value of a Lab color chromaticity indicator is greater than or equal to -2.0; a haze is less than or equal to 0.25%; and a process capability index CPK of the 3D glass ceramic with a length tolerance and a width tolerance within ±0.1 mm is greater than or equal to 0.8.

13. The chemically strengthened glass ceramic according to any one of claims 1 to 12, wherein a Vickers hardness of the chemically strengthened glass ceramic is greater than or equal to 650 kgf/mm²; and an impact resistance strength of the chemically strengthened glass ceramic is greater than or equal to 0.07J.

14. A preparation method of the chemically strengthened glass ceramic according to any one of claims 1 to 13, comprising:
placing a to-be-strengthened glass ceramic in a first salt bath to perform a first step of ion exchange, wherein a strengthening salt of the first salt bath comprises a sodium salt whose mass fraction is greater than or equal to 30%; and
placing a to-be-strengthened glass ceramic obtained after the first step of ion exchange in a second salt bath to perform a second step of ion exchange to obtain the chemically strengthened glass ceramic, wherein a strengthening salt of the second salt bath comprises a potassium salt whose mass fraction is greater than or equal to 85% and a lithium salt whose mass fraction is 0.005% to 1%.

15. The preparation method according to claim 14, wherein a temperature of the first step of ion exchange is 380°C to 490°C and a time period is 3h to 24h; and a temperature of the second step of ion exchange is 370°C to 450°C and a time period is 2 mins to 240 mins.

16. The preparation method according to claim 14 or 15, wherein the to-be-strengthened glass ceramic comprises a to-be-strengthened 3D glass ceramic, and the to-be-strengthened 3D glass ceramic is prepared in the following manner:
accommodating a glass ceramic raw material in a forming mold, and sequentially performing a preheating process, a forming process, a crystallization process, and an annealing cooling process to obtain the to-be-strengthened 3D glass ceramic, wherein crystallinity of the glass ceramic raw material is 5% to 75%, and a temperature of the crystallization process is greater than or equal to a temperature of the forming process.

17. The preparation method according to claim 16, wherein a temperature of the preheating process is within a range of 0°C to 780°C; the temperature of the forming process is within a range of 600°C to 800°C, and a forming pressure is within a range of 0 MPa to 0.9 MPa; the temperature of the crystallization process is within a range of 700°C to 900°C; and a temperature of the annealing cooling process is within a range of 0°C to 800°C.

18. A 3D glass ceramic, wherein an average transmittance of the 3D glass ceramic in an optical wavelength range of 400 nm to 700 nm is greater than or equal to 85%; a b value of a Lab color chromaticity indicator is greater than or equal to -2.0; and a haze is less than or equal to 0.25%.

19. The 3D glass ceramic according to claim 18, wherein a Vickers hardness of the 3D glass ceramic is greater than or equal to 650 kgf/mm²; and a process capability index CPK of the 3D glass ceramic with a length tolerance and a width tolerance within ±0.1 mm is greater than or equal to 0.8.

20. The 3D glass ceramic according to claim 18 or 19, wherein the 3D glass ceramic comprises the following components in mole percentage:
Li₂O: 10% to 25%;
SiO₂: 58% to 72%;
Na₂O and K₂O: 3% to 7%;
Al₂O₃: 2% to 8%;
P₂O₅+ZrO₂+TiO₂: 2% to 13%;
MgO+CaO+ZnO: 0% to 3%; and
B₂O₃: 0% to 5%.

21. The 3D glass ceramic according to any one of claims 18 to 20, wherein the 3D glass ceramic comprises a glass phase and a crystal phase, and a total mass content of the crystal phase in the 3D glass ceramic is greater than or equal to 50%.

22. The 3D glass ceramic according to any one of claims 18 to 21, wherein the 3D glass ceramic comprises a chemically strengthened 3D glass ceramic, and a compressive stress layer is on a surface of the chemically strengthened 3D glass ceramic.

23. A preparation method of a 3D glass ceramic, comprising:
accommodating a glass ceramic raw material in a forming mold, and sequentially performing a preheating process, a forming process, a crystallization process, and an annealing cooling process to obtain the 3D glass ceramic, wherein crystallinity of the glass ceramic raw material is 5% to 75%, and a temperature of the crystallization process is greater than or equal to a temperature of the forming process.

24. The preparation method according to claim 23, wherein a temperature of the preheating process is within a range of 0°C to 780°C; the temperature of the forming process is within a range of 600°C to 800°C, and a forming pressure is within a range of 0 MPa to 0.9 MPa; the temperature of the crystallization process is within a range of 700°C to 900°C; and a temperature of the annealing cooling process is within a range of 0°C to 800°C.

25. A glass cover, wherein the glass cover is made of the chemically strengthened glass ceramic according to any one of claims 1 to 13 or the 3D glass ceramic according to any one of claims 18 to 22.

26. An electronic device, comprising a housing assembled outside the electronic device and a circuit board located inside the housing, wherein the housing uses a glass ceramic, and the glass ceramic comprises the chemically strengthened glass ceramic according to any one of claims 1 to 13 or the 3D glass ceramic according to any one of claims 18 to 22.

27. The electronic device according to claim 26, wherein the housing comprises a display cover assembled on a front side of the electronic device, and the display cover comprises the glass ceramic.

28. The electronic device according to claim 26 or 27, wherein the housing comprises a rear cover assembled on a rear side of the electronic device, and the rear cover uses the glass ceramic.

29. The electronic device according to any one of claims 26 to 28, wherein the electronic device further comprises a camera assembly located inside the housing, the housing comprises a camera protective cover, the camera protective cover is disposed on the camera assembly, and the camera protective cover uses the glass ceramic.
